Europäisches Patentamt

European Patent Office

Office européen des brevets

(11) Numéro de publication : **0 406 080 B1**

(12) **FASCICULE DE BREVET EUROPEEN**

(45) Date de publication du fascicule du brevet :
**31.08.94 Bulletin 94/35**

(51) Int. Cl.⁵ : **H03M 1/18**, G01R 19/25,
G01V 1/24

(21) Numéro de dépôt : **90401789.4**

(22) Date de dépôt : **22.06.90**

(54) **Méthode et dispositif d'acquisition permettant une numérisation précise de signaux analogiques.**

(30) Priorité : **28.06.89 FR 8908758**

(43) Date de publication de la demande :
**02.01.91 Bulletin 91/01**

(45) Mention de la délivrance du brevet :
**31.08.94 Bulletin 94/35**

(84) Etats contractants désignés :
**DE GB IT NL**

(56) Documents cités :
**FR-A- 2 512 212**

(56) Documents cités :
**ELEKTRONIK, vol. 36, no. 14, 10 juillet 1987, pages 77-80; M. KREUZER:"Messverstärker mit schneller, hochauflösender Digitalisie-rung"**
**IEEE JOURNAL OF SOLID-STATE CIRCUITS, vol. SC-22, no. 6, décembre 1987, pages 930-938; H.OHARA et al.: "A CMOS program-mable self-calibrating 13-bit eight-channel data acquistion peripheral"**
**ANT, no. NTN-77/0517, US Air Force, 1977; P.H. VAN SLOUN: "Seismic gain control"**

(73) Titulaire : **INSTITUT FRANCAIS DU PETROLE**
**4, Avenue de Bois Préau**
**F-92502 Rueil-Malmaison (FR)**

(72) Inventeur : **Beauducel, Claude**
**8, rue Talon**
**F-60119 Henonville (FR)**

Jouve, 18, rue Saint-Denis, 75001 PARIS

## Description

La présente invention a pour objet une méthode et un dispositif pour l'acquisition de signaux analogiques par un ensemble de numérisation, permettant d'obtenir une grande précision dans les valeurs numériques obtenues.

L'acquisition de signaux analogiques et leur conversion en mots numériques interviennent dans de nombreux domaines. C'est le cas par exemple dans le domaine de la prospection sismique ou les signaux analogiques captés par des géophones ou des hydrophones et provenant de réflecteurs souterrains sont enregistrés de manière à établir des coupes sismiques représentatives du sous-sol. Généralement, ils sont amplifiés, echantillonnés et numérisés de manière à être accesibles à des traitements divers. Les signaux sismiques ont une très large dynamique de variations du fait de l'extension souvent considérable des zones explorées. Souvent cette dynamique excède les capacités des convertisseurs analogiques-numériques utilisés dans les chaînes d'acquisition qui fonctionnent au mieux sur 16 bits.

Par le brevet FR-A-2 512 212, on connaît un système d'acquisition de signaux sismiques comportant un amplificateur associé à des moyens d'échantillonnage et de conversion analogique-numérique, et un dispositif de commande automatique adapté à sélectionner les signaux avant amplification ou après amplification selon le niveau des signaux amplifiés, pour que les échantillons de signaux appliqués au convertisseur soient compatibles avec sa plage de conversion.

Par le brevet FR-A-2 625 634, on connaît une méthode permettant d'élargir la dynamique des signaux analogiques numérisables par un convertisseur numérique-analogique du type comportant une entrée pour l'application d'une tension de référence bien stable. La méthode antérieure consiste essentiellement à connecter à cette entrée un générateur de tension produisant deux tensions de même module mais de signes contraires. Suivant le signe du signal d'entrée à numériser, on applique soit la tension de référence positive, soit la tension négative. La méthode permet de gagner un bit de dynamique. Par le brevet FR-A-2 626 423, on connaît un autre système d'élargissement de dynamique comportant un amplificateur à gain fixe, un échantillonneur puis un convertisseur analogique-numérique auquel on applique une tension de référence bien fixe choisie parmi un ensemble de tensions stables obtenues par des subdivisions d'une même tension calibrée. Le choix de la tension de référence se fait par comparaison entre les tensions analogiques échantillonnées et les tensions stables dérivées de la tension calibrée. Un tel système permet donc de conserver une bonne précision dans la numérisation de signaux d'entrée relativement faibles et donc d'élargir de manière importante la dynamique de conversion à condition toutefois que les signaux d'entrée à numériser ne soient pas trop faibles et incompatibles avec le niveau de bruit ramené par le convertisseur.

Les amplificateurs sismiques à gain variable que l'on utilise pour faire de l'acquisition sismique sont souvent agencés pour délivrer des signaux amplifiés définis par une mantisse en virgule flottante qui est inférieure à la tension maximale numérisable par le convertisseur, et un exposant qui est généralement une puissance du nombre deux. Les mots numériques résultants comportent un certain nombre de bits définissant la valeur numérisée de la mantisse auxquels s'ajoutent la valeur numérisée en binaire de l'exposant. Les amplificateurs à virgule flottante donnent de bons résultats à condition que l'on connaisse avec précision le gain des différents étages d'amplification qui fournissent l'exposant de la tension amplifiée. Ce n'est pas toujours le cas. Le gain des étages, pour autant qu'il soit connu avec une grande précision au moment de leur construction en raison de la difficulté des réglages est sujet à des variations avec la température et au cours du temps. Des sauts de gain peuvent intervenir qui affectent la précision des échantillons de signal numérisés. La linéarité globale de l'amplificateur suivi du convertisseur est généralement différente de celle du convertisseur seul.

La méthode d'acquisition de signaux analogiques selon l'invention comporte l'amplification desdits signaux, leur échantillonnage et la numérisation des échantillons de signaux, et permet d'obtenir une grande précision dans les valeurs numériques obtenues.

Elle est caractérisée en ce qu'elle comporte la réalisation d'une suite de cycles successifs de numérisation comprenant chacun :

- l'application du signal à un amplificateur dont le gain est ajustable autour d'au moins une valeur nominale
- la numérisation d'un échantillon prélevé successivement sur le signal non amplifié et le signal amplifié, pour obtenir un premier mot numérique et un deuxième mot numérique;
- la sélection de l'échantillon numérisé dont l'amplitude est compatible avec la plage de variation dudit convertisseur;
- la mesure du gain réel appliqué à l'échantillon par la détermination du rapport entre le premier et le deuxième mot numérique; et
- l'ajustement éventuel de la valeur du gain effectivement appliqué si cette valeur est différente du gain nominal.

Le dispositif d'acquisition selon l'invention comprend un amplificateur, des moyens d'échantillonnage et au moins un convertisseur analogique-numérique adapté à la numérisation des échantillons issus des moyens d'échantillonnage.

Il est caractérisé en ce que l'amplificateur comporte au moins une unité d'amplification appliquant un gain dont la valeur est susceptible de varier autour d'un gain nominal, et pourvue de moyens d'ajustement de gain, les moyens d'échantillonnage comportant un premier échantillonneur pour l'échantillonnage direct du signal analogique et au moins un deuxième échantillonneur pour l'échantillonnage du signal amplifié issu de chaque unité d'amplification, le dispositif comportant en outre des moyens de commutation pour la connexion successive des sorties des échantillonneurs à l'entrée du convertisseur, des moyens de mémorisation du premier et du deuxième mot numérique issus du convertisseur suite à cette connexion successive, des moyens de sélection du mot numérique compatible avec la plage de variation du convertisseur, et un ensemble logique, coopérant avec les moyens d'ajustement pour détecter les écarts éventuels du gain effectif de chaque unité d'amplification par rapport au gain nominal, par comparaison desdits mots numériques afin d'ajuster éventuellement le gain de chaque unité d'amplification.

L'ensemble logique de détection comporte par exemple des moyens pour déterminer à chaque cycle une quantité proportionnelle à l'écart entre les valeurs de gain nominal et du gain réel mesuré en faisant le rapport du premier et du deuxième mot numérique et des moyens de pondération de cet écart connectés auxdits moyens d'ajustement de gain.

L'ensemble logique peut comporter un premier et un second registre à décalage tous les deux connectés à la sortie dudit convertisseur, et des moyens pour soustraire les contenus du premier et du second registre à décalage. Les moyens de pondération comportent par exemple un intégrateur.

On peut utiliser des moyens de pondération comportant une unité de traitement pour calculer une valeur moyenne du rapport entre le gain nominal de chaque unité d'amplificateur et son gain réel à partir du premier et du deuxième mot numérique contenus respectivement dans le premier et le second registres à décalage. L'unité de traitement comporte par exemple une mémoire pour un nombre fixé de valeurs successives dudit rapport.

D'autres caractéristiques et avantages de la méthode et du dispositif selon l'invention apparaitront mieux à la lecture de la description ci-après en se référant aux dessins annexés où:

- la Fig.1 montre le schéma synoptique d'un premier mode de réalisation du dispositif selon l'invention utilisant un intégrateur pour le lissage des corrections de gain;
- la Fig.2 montre un schéma synoptique d'un ensemble logique assurant la sélection des valeurs numériques et l'ajustement éventuel des gains d'amplification; et
- la fig.3 montre le schéma synoptique d'un second mode de réalisation ou l'on emploie des moyens numériques de mémorisation pour lisser les valeurs des corrections de gain à apporter aux unités d'amplification.

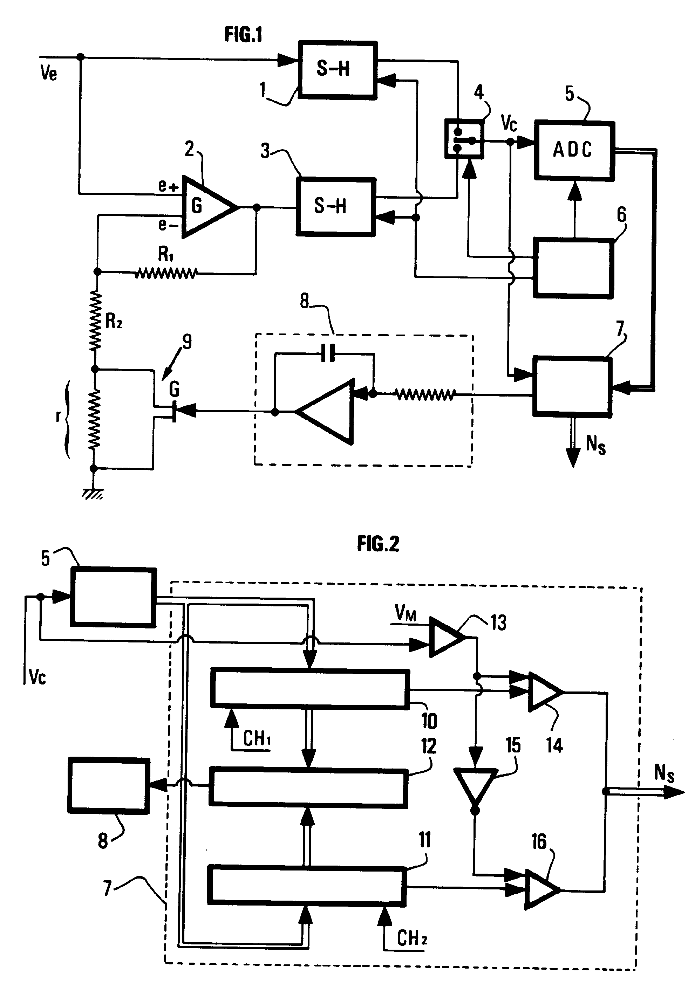

Sur la Fig. 1, on voit que les signaux analogiques Ve sont appliqués à l'entrée d'un premier échantillonneur 1 et à l'entrée d'un amplificateur 2 qui leur applique un gain nominal Gn. Le signal issu de l'amplificateur 2 est appliqué à un second échantillonneur 3. Les sorties des deux échantillonneurs 1,3 sont connectées à deux entrées d'un commutateur électronique 4. La sortie de celui-ci est connectée à l'entrée d'un convertisseur analogique-numérique 5 (C.A.N) produisant des mots numériques de longueur déterminée, par exemple 16 bits. Une unité de synchronisation 6 produit des signaux d'horloge pour commander les échantillonneurs 1,3 et le convertisseur (C.A.N) 5 à chaque cycle de numérisation d'échantillon. Il est adapté aussi à produire à chaque cycle un signal de commande du commutateur 4 permettant successivement d'appliquer à l'entrée du convertisseur C.A. N 5, l'échantillon non amplifié issu de l'échantillonneur 1 ou le même échantillon amplifié issu de l'amplificateur 2.

Le dispositif comporte aussi une unité logique 7 recevant les mots numérisés issus du convertisseur 5 et adaptée à produire des signaux de correction qui seront précisés par la suite. Ces signaux sont appliqués à l'entrée d'un intégrateur 8. Le gain de l'amplificateur 2 est commandé classiquement par un réseau de contre-réaction comportant une première résistance R1 connectée entre sa sortie s et son entrée inverseuse e- et deux résistances R2 et r en série pour connecter la même entrée inverseuse e- à la masse. La résistance r est constituée d'un transistor FET 9 dont le canal est connecté en parallèle sur une résistance morte. La sortie de l'intégrateur 8 est connectée à la grille (ou gate) du transistor 9. La valeur de la résistance r varie donc en fonction de la tension appliquée sur ladite grille.

L'unité logique de commande 7 comporte (Fig.2) deux registres 10,11 dont les entrées sont connectées parallèlement aux sorties du convertisseur 5. Une première impulsion CH1 commande l'accès au registre 10 du mot N1 résultant de la numérisation de l'échantillon non amplifié. Une seconde, CH2, commande de même l'accès au registre 11 du mot N2 correspondant à l'échantillon amplifié avec le gain G. Un soustracteur 12 compare les contenus respectifs des registres 10 et 11 et selon le résultat de la comparaison, produit un signal de valeur logique 0 ou 1 qui est appliqué à l'intégrateur 8. L'unité logique 7 comporte aussi un comparateur à seuil 13 à deux entrées. Une première entrée est reliée à l'entrée du convertisseur 5. Sur la seconde est appliquée une tension de référence Vm correspondant à l'amplitude maximale que le convertisseur 5 est susceptible de convertir en mot numérique. La sortie du comparateur a seuil 13 est connectée à l'entrée de commande d'une première porte ET 14 et, par l'intermédiaire d'un inverseur logique 15, à l'entrée de commande d'une seconde porte ET 16. Les sorties respectives des registres 10 et 11 sont connectées respectivement aux entrées des portes 14 et 16. Les sorties interconnectées des deux portes ET 14,16 constituent la sortie de l'unité de comparaison.

Le principe général de fonctionnement du dispositif consiste, pour chaque cycle d'échantillonnage, à effectuer une double conversion numérique, la première pour l'échantillon non amplifié issu de l'échantillonneur 1, la seconde pour l'échantillon amplifié issu de l'échantillonneur 3 et à vérifier si le gain réel G de l'amplificateur est bien conforme au gain nominal Gn en faisant le rapport entre les mots numériques respectivement obtenus N2 et N1, et à corriger une différence éventuelle. La comparaison des gains G et Gn peut s'effectuer de façon équivalente en comparant le mot numérique N2 obtenu réellement après amplification avec le mot N1 auquel on applique le gain nominal Gn.

Pour chaque échantillon analogique mémorisé dans les échantillonneurs 1 et 3,

- on connecte successivement au moyen du commutateur 4, les sorties des échantillonneurs 1,3 à l'entrée du convertisseur 5. Les deux mots numériques qui en résultent sont inclus successivement le premier dans le registre 10 de l'unité de comparaison 7, le second dans l'autre registre 11. On fait une première comparaison de niveau. Si le signal à l'entrée du dispositif est suffisamment grand pour qu'après amplification de gain G, son amplitude excède la tension maximale susceptible d'être numérisée par le convertisseur 5, l'unité de comparaison choisit le premier mot numérique N1 correspondant à l'échantillon non amplifié. Ceci est réalisé par le comparateur à seuil 13 qui ouvre la porte 14 et ferme l'autre porte 16. Dans le cas contraire, si le signal amplifié est dans la fenêtre de tension numérisable par le convertisseur, l'unité de comparaison effectue une seconde comparaison entre le second mot numérique produit N2 et un troisième mot N3 pour vérifier si le gain réel G appliqué à l'échantillon amplifié correspond bien au gain nominal Gn mesuré au moment du réglage final de l'amplificateur. Ce mot N3 est obtenu en multipliant le mot numérique N1 mémorisé dans le registre 10 (échantillon non amplifié) par le gain nominal Gn. Si le gain nominal est par exemple égal à deux élevé à la puissance m (ou m est un entier quelconque) la multiplication se résume, comme il est bien connu, en un décalage de m rangs du contenu du registre contenant le mot N1. Le mot N1∗Gn dans le registre 11 est appliqué comme le mot N2 au soustracteur 12 qui forme donc la différence N2-N1∗Gn ou ce qui est équivalent la différence $N1(\frac{N2}{N1}-Gn)=N1(Gr-Gn)$.

Si N2-N1∗Gn-0, le comparateur 12 émet un 0 logique. Autrement, il émet un 1 logique. Le signal logique issu du soustracteur 12, est appliqué à l'intégrateur 8. La variation de tension qui en résulte, à la sortie de l'intégrateur 8, modifie légèrement le gain de l'amplificateur 2 de manière à lui donner un gain correspondant au gain nominal.

Par la porte ET 16, on commande alors la sortie du mot numérique N2 correspondant au signal amplifié.

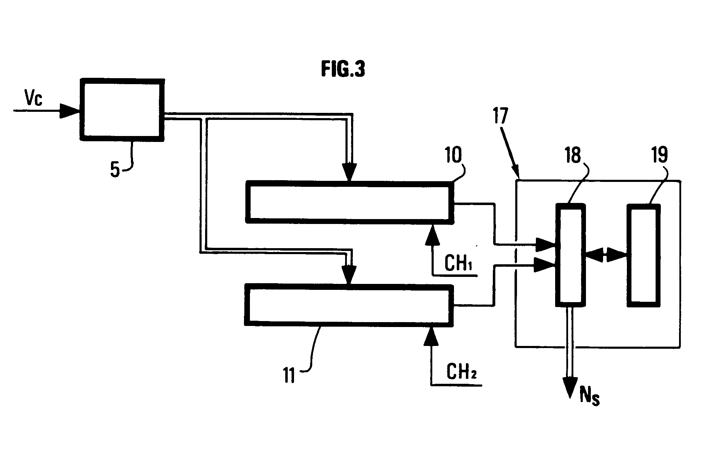

Suivant la variante de réalisation montrée à la Fig. 3, la correction des écarts éventuels entre le gain réel G de l'amplificateur 5 et le gain nominal Gn est effectuée non plus par intégration mais en faisant une moyenne de leur rapport sur un certain nombre de cycles d'échantillonnage successifs. La valeur réelle du gain G étant donnée par le rapport N2/N1, on détermine le rapport Gn/G entre le gain nominal et le gain réel en calculant le produit C= Gn∗N1/N2. Les registres 10 et 11 de l'unité logique 7 sont connectés à un ensemble de traitement 17 comportant un élément de calcul 18 adapté, à chaque cycle d'échantillonnage et d'amplification, à déterminer la valeur du coefficient C et une mémoire 19, par exemple du type FIFO bien connu des spécialistes, capable de mémoriser un certain nombre p de mots numériques. Les valeurs successives de C sont introduites dans la mémoire 19. A chaque cycle, l'élément de calcul 18 détermine la valeur moyenne des p dernières valeurs du coefficient C mémorisées. La valeur moyenne du rapport est alors utilisée pour modifier la valeur numérisée de chacun des échantillons successifs. L'élément de calcul 18 réalise cette modification en multipliant par cette valeur moyenne le mot numérisé N2 correspondant à chaque échantillon amplifié.

Dans le mode de réalisation décrit, on a considéré le cas d'un amplificateur à gain fixe ajustable. On ne sortirait pas du cadre de l'invention toutefois en étendant le principe de correction décrit à un amplificateur dont le gain peut prendre plusieurs valeurs différentes avec des possibilités d'ajustage autour de ces valeurs. Dans ce cas, le dispositif peut comporter par exemple plusieurs étages de gains différents en parallèle, un convertisseur analogique-numérique connecté à chaque cycle d'échantillonnage successivement avec tous les étages par l'intermédiaire d'un multiplexeur, des moyens de correction des écarts entre les gains nominaux des différents étages d'amplification et les gains réels, analogues à ceux qui ont été décrits à titre d'exemples, et des moyens de sélection du gain de l'étage donnant la valeur numérisée la plus précise compte tenu du convertisseur utilisé.

**Revendications**

1. Méthode d'acquisition d'un signal analogique (Ve), comportant l'amplification du signal, son échantillonnage et la numérisation des échantillons par un convertisseur analogique-numérique, permettant d'obtenir une grade précision dans les valeurs numériques obtenues, caractérisé en ce qu'elle comporte la réalisation d'une suite de cycles successifs de numérisation comprenant chacun :

- l'application du signal à un amplificateur (2) dont le gain (G) est ajustable autour d'au moins une valeur nominale (Gn)
- la numérisation d'un échantillon prélevé successivement sur le signal non amplifié et le signal amplifié, pour obtenir un premier mot numérique (N1) et un deuxième mot numérique (N2);
- la sélection de l'échantillon numérisé dont l'amplitude est compatible avec la plage de variation dudit convertisseur;
- la mesure du gain réel (G) appliqué à l'échantillon par la détermination du rapport entre le premier et le deuxième mot numérique; et
- l'ajustement éventuel de la valeur (G) du gain effectivement appliqué si cette valeur est différente du gain nominal (Gn).

2. Dispositif d'acquisition d'un signal analogique (Ve) comprenant un amplificateur (2), des moyens d'échantillonnage (1,3) et au moins un convertisseur analogique-numérique (5) adapté à la numérisation des échantillons issus des moyens d'échantillonnage, caractérisé en ce que l'amplificateur comporte au moins une unité d'amplification (2) appliquant un gain (G) dont la valeur est susceptible de varier autour d'un gain nominal (Gn), et pourvue de moyens premier (9) d'ajustement de gain, les moyens d'échantillonnage comportant un premier échantillonneur (1) pour l'échantillonnage direct du signal analogique et au moins un deuxième échantillonneur (3) pour l'échantillonnage du signal amplifié issu de chaque unité d'amplification, le dispositif comportant en outre des moyens de commutation (4) pour la connexion successive des sorties des échantillonneurs (1, 3) à l'entrée du convertisseur (5), des moyens de mémorisation du premier et du deuxième mot numérique issus du convertisseur (5) suite à cette connexion successive, des moyens de sélection du mot numérique compatible avec la plage de variation du convertisseur (5), et un ensemble logique (7), coopérant avec les moyens d'ajustement (9) pour détecter les écarts éventuels du gain effectif (G) de chaque unité d'amplification par rapport au gain nominal (Gn), par comparaison desdits mots numériques afin d'ajuster éventuellement le gain (G) de chaque unité d'amplification.

3. Dispositif selon la revendication 2, caractérisé en ce que l'ensemble logique de détection comporte des moyens (7) pour déterminer à chaque cycle une quantité proportionnelle à l'écart entre les valeurs de gain nominal (Gn) et du gain réel (G) mesuré en faisant le rapport du premier et du deuxième mot numérique et des moyens de pondération dudit écart connectés auxdits moyens d'ajustement (9) de gain.

4. Dispositif selon la revendication 3, caractérisé en ce que l'ensemble logique (7) comporte un premier et un second registre à décalage (10, 11) tous les deux connectés à la sortie dudit convertisseur (5), et des moyens (12) pour soustraire les contenus du premier et du second registre à décalage.

5. Dispositif selon la revendication 4, caractérisé en ce que les moyens de pondération comportent un intégrateur (8).

6. Dispositif selon la revendication 4, caractérisé en ce que les moyens de pondération (17) comportent une unité de traitement (18) pour calculer une valeur moyenne du rapport entre le gain nominal de chaque unité d'amplificateur (2) et son gain réel (G) à partir du premier et du deuxième mot numérique contenus respectivement dans le premier et le second registre à décalage (10, 11).

7. Dispositif selon la revendication 6, caractérisé en ce que l'unité de traitement (18) comporte une mémoire (19) pour un nombre fixé de valeurs successives dudit rapport.

8. Dispositif selon la revendication 5, caractérisé en ce que ladite unité d'amplification (2) comporte un réseau de contre-réaction pourvu d'une résistance (9) ajustable électroniquement connectée à la sortie de l'intégrateur (8).

9. Dispositif selon la revendication 6, caractérisé en ce que l'unité de traitement (18) est adaptée à corriger les valeurs numérisées issues du convertisseur (5) en fonction de ladite valeur moyenne.

**Patentansprüche**

1. Verfahren zur Abtastung eines Analogsignals (Ve), umfassend die Verstärkung des Signals, seine Abtastung und Digitalisierung der Abtastungen durch einen Analog-Digital-Wandler, wobei es ermöglicht wird, einen Genauigkeitsgrad in den erhaltenen digitalen Werten zu erhalten, dadurch gekennzeichnet, daß es die Realisierung einer Folge aufeinanderfolgender Digitalisierungs-Zyklen umfasst, die je umfassen:

- das Anlegen des Signals an einen Verstärker (2), dessen Verstärkung (G) einstellbar um wenigstens einen Nominalwert (Gn) ist,
- die Digitalisierung einer aufeinanderfolgend an dem nicht-verstärkten Signal und dem verstärkten Signal entnommenen Abtastung oder Probe, um ein erstes digitales Wort (N1) und zweites digitales Wort (N2) zu erhalten;
- die Auswahl der digitalisierten Probe bzw. Abtastung, deren Amplitude kompatibel mit dem Variationsbereich dieses Wandlers ist;
- die Messung der reellen an die Probe gelegten Verstärkung (G) durch Bestimmung des Verhältnisses zwischen dem ersten und dem zweiten digitalen Wort und
- gegebenenfalls die Einstellung des Wertes (G) der tatsächlich angelegten Verstärkung, wenn dieser Wert sich von der Nennverstärkung (Gn) unterscheidet.

2. Vorrichtung zum Erfassen eines Analogsignals (Ve), umfassend: einen Verstärker (2), Abtastmittel (1, 3) und wenigstens einen Analog-Digital-Wandler (5), der zur Digitalisierung der aus den Abtastmitteln stammenden Abtastungen ausgelegt ist, dadurch gekennzeichnet, daß der Verstärker wenigstens eine Verstärkereinheit (2) umfasst, die eine Verstärkung (G) anlegt, deren Wert in der Lage ist, um eine Nenn-Verstärkung (Gn) zu variieren und mit Mitteln (9) zum Einstellen der Verstärkung versehen ist, wobei die Abtastmittel einen ersten Abtaster (1) zur direkten Abtastung des Analogsignals und wenigstens einen zweiten Abtaster (3) für die Abtastung des verstärkten Signals umfassen, das aus jeder Verstärkungseinheit stammt, wobei die Vorrichtung im übrigen Umschaltmittel (4) umfasst, um die aufeinanderfolgende Verbindung der Ausgänge der Abtaster (1, 3) mit dem Eingang des Wandlers (5), Mittel zum Speichern des ersten und zweiten digitalen aus dem Wandler (5) stammenden Wortes anschliessend an diese Folgeverbindung, Mittel zur Auswahl des digitalen Wortes, das mit dem Bereich der Variation des Wandlers (5) kompatibel ist und eine logische Anordnung (7) umfasst, die mit den Einstellmitteln (9) zusammenwirkt, um die eventuellen Abweichungen der effektiven Verstärkung (G) jeder Verstärkungseinheit, bezogen auf die Nennverstärkung (Gn) durch Vergleich dieser digitalen Worte zu ermitteln, um eventuell die Verstärkung (G) jeder Verstärkungseinheit einzustellen.

3. Vorrichtung nach Anspruch 2, dadurch gekennzeichnet, daß die logische Ermittlungs- oder Detektor-Anordnung Mittel (7) umfasst, um bei jedem Zyklus eine Menge proportional zur Abweichung zwischen den Werten der Nennverstärkung (Gn) und der gemessenen reellen Verstärkung (G) zu bestimmen, in dem das Verhältnis des ersten und des zweiten digitalen Wortes hergestellt wird und Wichtungsmittel, die Abweichung, die mit diesen Verstärkungseinstellmitteln (9) verbunden sind.

4. Vorrichtung nach Anspruch 3, dadurch gekennzeichnet, daß die logische Anordnung (7) ein erstes und ein zweites Schieberegister (10, 11) umfasst, die beide mit dem Ausgang dieses Wandlers (5) verbunden sind sowie Mittel (12), um die Inhalte des ersten und des zweiten Schieberegisters abzuziehen.

5. Vorrichtung nach Anspruch 4, dadurch gekennzeichnet, daß die Wichtungsmittel einen Integrator (8) umfassen.

6. Vorrichtung nach Anspruch 4, dadurch gekennzeichnet, daß die Wichtungsmittel (17) eine Verarbeitungseinheit (18) umfassen, um einen mittleren Wert des Verhältnisses zwischen der Nennverstärkung jeder Verstärkungseinheit (2) und ihrer reellen Verstärkung (G) ausgehend von dem ersten und dem zweiten digitalen Wort zu berechnen, die jeweils in dem ersten und dem zweiten Schieberegister (10, 11) enthalten sind.

7. Vorrichtung nach Anspruch 6, dadurch gekennzeichnet, daß die Verarbeitungseinheit (18) einen Speicher (19) für eine festgelegte Anzahl aufeinanderfolgender Werte dieses Verhältnisses umfasst.

8. Vorrichtung nach Anspruch 5, dadurch gekennzeichnet, daß diese Verstärkungseinheit (2) ein Gegenkopplungsnetz umfasst, das mit einem elektronisch einstellbaren Widerstand (9) versehen ist, der mit dem Ausgang des Integrators (8) verbunden ist.

9. Vorrichtung nach Anspruch 6, dadurch gekennzeichnet, daß die Verarbeitungseinheit (18) so ausgelegt ist, daß sie die digitalisierten, aus dem Wandler (5) stammenden Werte als Funktion dieses mittleren Wertes korrigiert.

**Claims**

1. A method for acquiring an analog signal (Ve) consisting in amplifying the signal, sampling it and digitising the samples using an analog-to-digital convertor, giving a high degree of accuracy in the digital values obtained, characterised in that it involves carrying out a series of successive digitisation cycles, each consisting in:

- applying the signal to an amplifier (2) whose gain (G) may be varied on either side of a nominal value (Gn);
- digitising a sample taken successively on the non-amplified signal and the amplified signal to obtain a first digital word (N1) and a second digital word (N2);
- selecting the digitised sample whose amplitude is compatible with the range of variation of the convertor;
- measuring the real gain (G) applied to the sample by determining the ratio between the first and the second digital word; and
- adjusting if necessary the value (G) of the gain actually applied if this value differs from the nominal gain (Gn).

2. A device for acquiring an analog signal (Ve) comprising an amplifier (2), sampling means (1, 3) and at least one analog-to-digital convertor (5) programmed to digitise samples from the sampling means, characterised in that the amplifier has at least one amplifying unit (2) applying a gain (G) whose value is likely to vary around a nominal gain (Gn) and provided with a means (9) for adjusting the gain, the sampling means having a first sampler (1) for sampling the analog signal directly and at least a second sampler (3) for sampling the amplified sample from each amplifying unit, the device also having switching means (4) to connect the outputs of the samplers (1, 3) successively to the input of the convertor (5), memory means for the first and second digital words issued by the convertor (5) following this successive connection, means for selecting the digital word compatible with the range of variation of the convertor (5) and a logic unit (7) co-operating with adjusting means (9) for detecting any differences between the actual gain (G) of each amplifying unit and the nominal gain (Gn) by comparing the digital words so as to adjust the gain (G) of each amplifying unit if necessary.

3. A device in accordance with claim 2, characterised in that the logic unit used for detecting purposes has means (7) for determining at each cycle a quantity proportional to the difference between the values of nominal gain (Gn) and real gain (G) measured by determining the ratio of the first and second digital word and means for weighting the difference connected to the means (9) for adjusting the gain.

4. A device in accordance with claim 3, characterised in that the logic unit (7) has a first and a second shift register (10, 11), both being connected to the output of the convertor (5) and means (12) for subtracting the contents of the first and second shift registers.

5. A device in accordance with claim 4, characterised in that the weighting means comprises an integrator (8).

6. A device in accordance with claim 4, characterised in that the weighting means (17) comprise a processing unit (18) for calculating an average value of the ratio between the nominal gain of each amplifying unit (2) and its real gain (G) on the basis of the first and second digital words contained respectively in the first and second shift registers (10, 11).

7. A device in accordance with claim 6, characterised in that the processing unit (18) comprises a memory (19) for a fixed number of successive values of the ratio.

8. A device in accordance with claim 5, characterised in that the amplifying unit (2) comprises a reverse feed-back network provided with an adjustable resistor (9) electronically connected to the output of the integrator (8).

9. A device in accordance with claim 6, characterised in that the processing unit (18) is programmed to correct the digitised values issued by the convertor (5) depending on their average value.

**FIG.1**

**FIG.2**

## FIG.3